# DEMANDE DE BREVET EUROPEEN

(11) **EP 1 732 221 A2**
(43) Date de publication de la demande: **13.12.2006**
(21) Numéro de dépôt: 06290877.7
(22) Date de dépôt: 31.05.2006
(51) Int. Cl.: H03K 3/02, H05H 1/36

(54) **Générateur électrique à haute tension**

(30) Priorité: 10.06.2005 FR 0505978
(71) Demandeur: GIAT Industries, 78000 Versailles (FR)
(72) Inventeur: Aragier, Marc, 92500 Rueil Malmaison (FR); Nermot, Bertrand, 78530 Buc (FR)
(74) Mandataire: Célanie, Christian

(57) **Abrégé**

L'invention a pour objet un générateur électrique 1 à haute tension pour alimenter un récepteur, notamment pour un canon électrothermique-chimique. Ce générateur comprend au moins deux modules énergétiques 3a, 3b, 3c déclenchés séquentiellement et incorporant chacun au moins un condensateur 4 et un organe de coupure 7 commandé par un boîtier de déclenchement 8.

Ce générateur est caractérisé en ce qu'il comprend un moyen concentrateur unique 13 qui reçoit en parallèle les impulsions fournies par les modules énergétiques 3a, 3b, 3c et qui les transmet au récepteur 2, le moyen concentrateur incorporant une inductance unique 16 reliée d'un côté au récepteur 2 et de l'autre à tous les modules énergétiques 3a, 3b, 3c.

## Description

Le domaine technique de l'invention est celui des générateurs électriques pour armes électriques et notamment pour canons électrothermiques chimiques.

Les canons électrothermiques chimiques (ou ETC) sont bien connus et sont en cours de développement depuis une dizaine d'années. Ils mettent en oeuvre un générateur de plasma qui est disposé au voisinage d'une charge propulsive.

Ce générateur ou torche à plasma engendre des gaz à haute pression (de l'ordre de 500 MPa) et à haute température (supérieure à 1000 K) qui permettent de communiquer à une charge propulsive une part d'énergie d'origine électrique qui accroît la pression des gaz et la vitesse du projectile.

Un tel générateur de plasma est alimenté en courant électrique à haute tension (pouvant aller au delà de 20 kilo Volts) par un générateur électrique comportant des moyens de mise en forme de l'impulsion (en anglais PFN ou Pulse Forming Network) .

Les générateurs PFN connus utilisent généralement plusieurs modules énergétiques qui sont déclenchés séquentiellement par un boîtier de commande.

Chaque module comporte une capacité qui est chargée préalablement à partir d'un moyen de charge, un organe de coupure qui permet de commander la décharge de la capacité et qui est piloté par le boîtier de commande, et une inductance qui permet de retarder l'établissement du courant d'allumage, ce qui prolonge la durée globale de l'impulsion à la valeur souhaitée.

Un des principaux problèmes rencontrés avec les générateurs connus est leur encombrement.

Les tensions et énergies mises en oeuvre conduisent à définir des inductances volumineuses (de l'ordre de 13 dm³) qui réduisent les possibilités d'intégration dans un véhicule de combat.

C'est le but de l'invention que de proposer un générateur permettant de pallier de tels inconvénients.

Ainsi le générateur selon l'invention a une architecture compacte qui facilite son intégration dans un véhicule.

Ainsi l'invention a pour objet un générateur électrique à haute tension pour alimenter un récepteur, notamment pour un canon électrothermique-chimique, générateur comprenant au moins deux modules énergétiques déclenchés séquentiellement et incorporant chacun au moins un condensateur et un organe de coupure commandé par un boîtier de déclenchement, générateur caractérisé en ce qu'il comprend un moyen concentrateur unique qui reçoit en parallèle les impulsions fournies par les modules énergétiques et qui les transmet au récepteur, le moyen concentrateur incorporant une inductance unique reliée d'un côté au récepteur et de l'autre à tous les modules énergétiques.

Chaque module énergétique est de préférence incorporé dans un boîtier blindé électriquement et dont une enveloppe interne est reliée à la masse électrique.

Le concentrateur pourra être incorporé dans un boîtier blindé électriquement et dont une enveloppe interne sera reliée à la masse électrique.

Chaque connecteur d'entrée et de sortie d'un module énergétique ou du concentrateur pourra être réalisé sous une forme coaxiale, un contact périphérique du connecteur étant relié à la masse électrique.

Chaque câble conducteur mis en oeuvre et reliant un des boîtiers du générateur à un autre boîtier et/ou au récepteur sera de préférence un câble coaxial.

L'invention sera mieux comprise à la lecture de la description qui va suivre d'un mode particulier de réalisation, description faite en référence aux dessins annexés et dans les quels :
- la figure 1 est une vue schématique d'un générateur selon l'art antérieur,
- la figure 2 est une vue schématique d'un générateur selon l'invention.

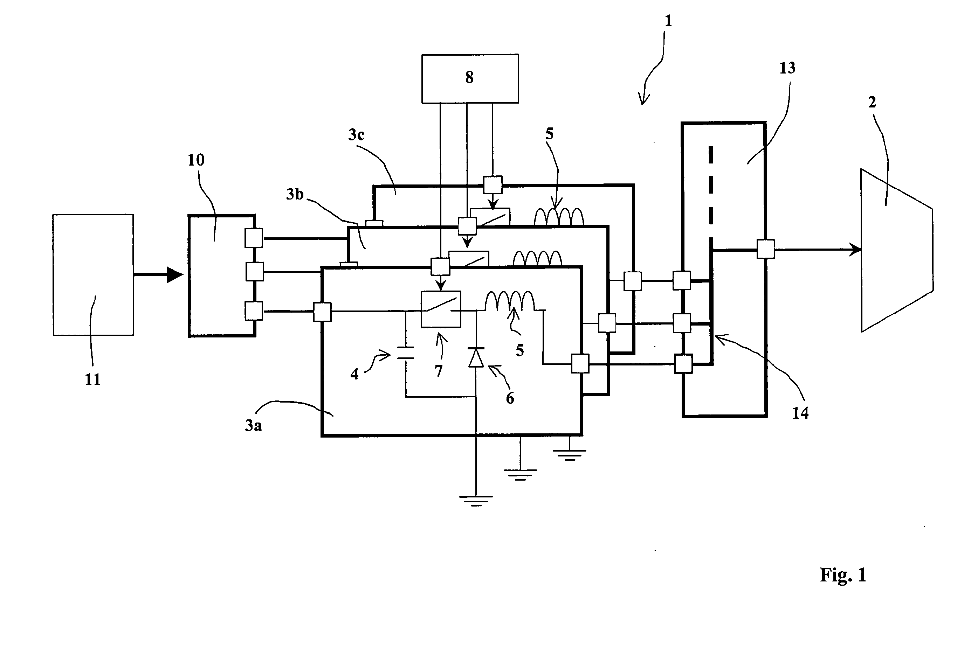

En se reportant à la figure 1, un générateur électrique 1 selon l'art antérieur est destiné à alimenter en impulsions électriques un récepteur 2 qui est ici une arme dont on a représenté de façon schématique le coin de culasse.

L'arme est par exemple un canon électro-thermique chimique. Les impulsions de courant sont envoyées, au travers du coin de culasse, vers une torche à plasma qui est en contact avec la charge propulsive. Cette torche n'est pas représentée et elle ne fait pas l'objet de la présente invention.

On pourra se reporter aux brevets FR2807610 et FR-2807611 qui décrivent des exemples de torches à plasma utilisables.

Afin d'assurer l'allumage de la charge propulsive avec les caractéristiques d'intensité et de forme de courant souhaitées, le générateur est constitué par un réseau de mise en forme d'impulsions (PFN) .

Ce réseau comprend plusieurs modules énergétiques 3a, 3b, 3c identiques (ici trois modules pour la clarté de la figure). Il est bien entendu possible de faire varier le nombre de modules en fonction des caractéristiques d'impulsions souhaitées.

Chaque module 3 incorpore un circuit de décharge associant un condensateur 4, une inductance 5, une diode dite de "roue libre" 6 et un organe de coupure 7, tel qu'un thyristor, qui est commandé par un boîtier électronique de déclenchement 8. La diode de roue libre peut -être placée soit en aval, comme sur la figure, soit en amont de l'organe de coupure, c'est à dire en parallèle avec le condensateur 4.

Chaque module 3 est organisé sous la forme d'un boîtier distinct. Les modules 3a, 3b, 3c sont alimentés en haute tension (pouvant aller au delà de 20000 Volts) par une alimentation haute tension 10 qui est également incorporée dans un boîtier.

L'alimentation haute tension est d'un type classique et n'est pas décrite en détails. Elle comporte plusieurs étages de circuits qui élèvent le niveau de tension d'un courant fourni par une source 11 qui pourra être une batterie.

Les modules 3a, 3b et 3c fournissent les impulsions de tension à l'arme 2 via un concentrateur 13 qui est essentiellement constitué par un boîtier renfermant un conducteur 14 reliant entre elles les sorties 15a, 15b et 15c des différents modules 3a, 3b et 3c.

Un des principaux inconvénients d'un tel générateur 1 est son volume. En effet les niveaux d'intensité mis en oeuvre (plusieurs dizaines de kilo ampères) interdisent l'emploi d'inductances à noyau magnétique. En effet, avec de telles intensités un noyau magnétique est complètement saturé et sa perméabilité magnétique voisine de celle de l'air. Le gain qui pourrait être obtenu en utilisant un noyau magnétique serait donc nul. Un tel niveau d'intensité génère par ailleurs des forces de Laplace considérables qui conduisent à renforcer mécaniquement les circuits.

Concrètement les inductances mises en oeuvre ont un volume de l'ordre de 13 dm³, ce qui conduit pour un générateur à 3 modules à un volume minimal des inductances de 49 dm³ et à un volume de 91 dm³ pour les inductances d'un générateur à sept modules.

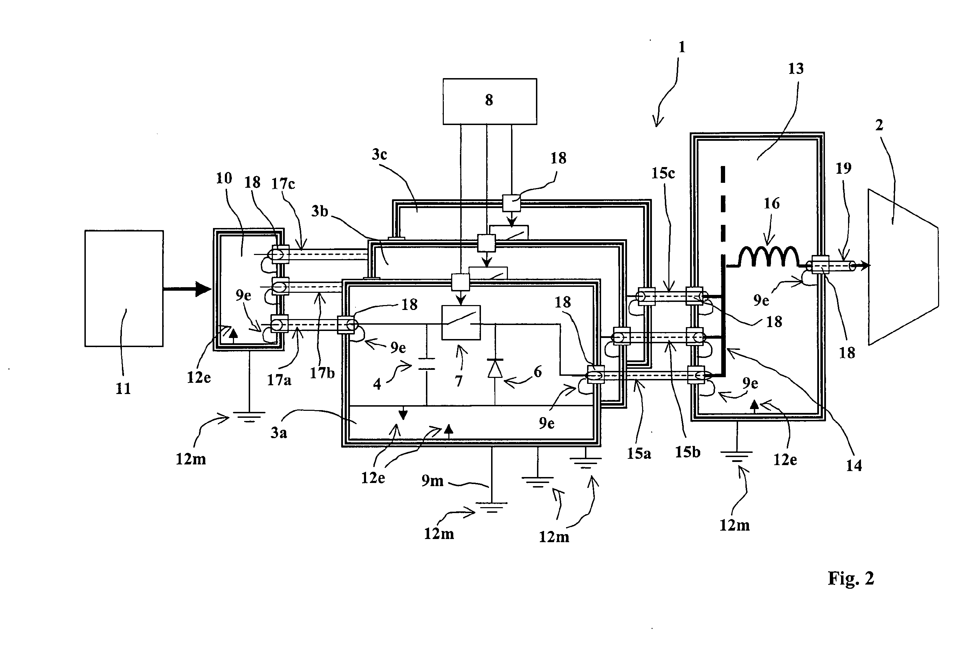

La figure 2 montre un mode de réalisation d'un générateur selon l'invention.

Ce générateur diffère principalement du précédent en ce que les modules énergétiques ne comportent plus d'inductance et en ce que le concentrateur 13 incorpore une inductance unique 16 qui est interposée entre le conducteur 14 et l'arme 2.

Les modules énergétiques 3 sont donc plus légers et moins encombrants.

Par ailleurs chaque module énergétique est incorporé dans un boîtier qui est blindé électriquement et qui comporte donc une double enveloppe conductrice dont la paroi externe est reliée à la masse mécanique 12m de l'arme par une connexion 9m. La paroi interne du boîtier est isolée électriquement de la paroi externe et reliée à la masse électrique 12e des différents circuits.

Le concentrateur 13 et l'alimentation haute tension 10 sont aussi disposés dans des boîtiers blindés électriquement dont les parois internes sont isolées électriquement des parois externes et reliées à la masse électrique 12e. Les parois externes des boîtiers sont reliées à la masse de l'arme 12 m.

Tous les connecteurs 18 d'entrée et de sortie dans les différents boîtiers des modules, du concentrateur et de l'alimentation sont par ailleurs réalisés sous la forme de connecteurs coaxiaux. Le contact central de ces connecteurs conduit le courant utile et le contact périphérique est relié par une connexion 9e à la masse électrique 12e via la paroi interne du boîtier considéré.

Enfin les différents câbles mis en oeuvre sont des câbles coaxiaux.

On a ainsi représenté sur la figure 2 les câbles coaxiaux:
17a, 17b, 17c reliant l'alimentation 10 aux modules 3, 15a, 15b, 15c reliant les modules 3 au concentrateur 13, 19 reliant le concentrateur 13 à l'arme 2.

De telles dispositions permettent de minimiser les efforts de Laplace s'exerçant sur les différents conducteurs du générateur et le rayonnement magnétique induit par le passage du courant. Il est ainsi possible de réduire globalement la masse du générateur.

Grâce à l'invention on remplace donc les trois inductances 5 des modules par une seule inductance 16 dans le concentrateur. Cette inductance sera dimensionnée de façon à permettre d'obtenir la forme d'onde souhaitée pour le courant d'initiation et pour supporter sans dommages le passage des courants de décharge des différents modules 3. Si une telle inductance est plus grosse que celle qui était incorporée dans un seul des modules, elle occupe néanmoins un volume inférieur à celui qui était occupé par l'ensemble des inductances.

A titre d'exemple, on peut estimer (à caractéristiques de courant équivalentes) le volume occupé par cette inductance 16 à 16 dm³. Ce volume est bien inférieur à celui occupé par les trois inductances du mode de réalisation précédent (49 dm³).

Le générateur selon invention peut bien entendu être adapté à d'autres utilisations dans lesquelles un générateur à mise en forme d'impulsion (PFN) est utile, par exemple pour les canons électromagnétiques.

## Revendications

1. Générateur électrique (1) à haute tension pour alimenter un récepteur (2), notamment pour un canon électrothermique-chimique, générateur comprenant au moins deux modules énergétiques (3a, 3b, 3c) déclenchés séquentiellement et incorporant chacun au moins un condensateur (4) et un organe de coupure (7) commandé par un boîtier de déclenchement (8), générateur ***caractérisé en ce qu*'**il comprend un moyen concentrateur unique (13) qui reçoit en parallèle les impulsions fournies par les modules énergétiques (3a, 3b, 3c) et qui les transmet au récepteur (2), le moyen concentrateur (13) incorporant une inductance unique (16) reliée d'un côté au récepteur (2) et de l'autre à tous les modules énergétiques (3a, 3b, 3c).

2. Générateur électrique selon la revendication 1, **caractérisé en ce que** chaque module énergétique (3a, 3b, 3c) est incorporé dans un boîtier blindé électriquement et dont une enveloppe interne est reliée à la masse électrique (12e).

3. Générateur électrique selon la revendication 2, **caractérisé en ce que** le concentrateur (13) est incorporé dans un boîtier blindé électriquement et dont une enveloppe interne est reliée à la masse électrique (12e).

4. Générateur électrique selon une des revendications 2 ou 3, **caractérisé en ce que** chaque connecteur (18) d'entrée et de sortie d'un module énergétique (3a, 3b, 3c) ou du concentrateur (13) est réalisé sous une forme coaxiale, un contact périphérique du connecteur étant relié à la masse électrique (12e).

5. Générateur électrique selon une des revendications 2 à 4, **caractérisé en ce que** chaque câble conducteur (15a, 15b, 15c, 17a, 17b, 17c, 19) mis en oeuvre et reliant un des boîtiers du générateur à un autre boîtier et/ou au récepteur est un câble coaxial.
